# DEMANDE DE BREVET EUROPEEN

(11) **EP 1 126 515 A1**
(43) Date de publication de la demande: **22.08.2001**
(21) Numéro de dépôt: 01400368.5
(22) Date de dépôt: 12.02.2001
(51) Int. Cl.: H01L 21/331, H01L 29/423

(54) **Procédé de fabrication de transistor bipolaire à double hétérojonction sur matériau III-V**

(30) Priorité: 14.02.2000 FR 0001804
(71) Demandeur: ALCATEL, 75008 Paris (FR)
(72) Inventeur: Blayac, Sylvain, 94230 Cachan (FR); Riet, Muriel, 94230 Cachan (FR); Berdaguer, Philippe, 94230 Cachan (FR)
(74) Mandataire: Ballot, Paul

(57) **Abrégé**

L'invention concerne un procédé de fabrication d'un transistor (1) bipolaire à double hétérojonction sur matériau III-V comprenant successivement au moins une sous-couche de collecteur, une couche de collecteur, une couche de base et une couche métallique (10) déposée sur ladite couche de base ; la dite couche métallique (10) étant prolongée vers un plot de contact (110) de la base par un « pont à air » métallique (100) sous gravé, caractérisé en ce que la réalisation dudit « pont à air » (100) comporte les étapes suivantes :
- la réalisation d'une première gravure localisée sous ledit pont, cette première gravure étant sélective de manière à graver latéralement la couche de sous-collecteur ; et
- la réalisation d'une seconde gravure localisée sous ledit pont, cette seconde gravure étant sélective de manière à graver verticalement la couche du collecteur.

## Description

L'invention concerne le domaine des composants électroniques et optoélectroniques réalisés sur matériau III-V et destinés à être utilisés dans le cadre d'applications de transmission de données haut débit sur fibres optiques.

L'invention concerne plus spécifiquement le domaine des transistors bipolaires à hétérojonction réalisés sur matériau III-V. L'objet de l'invention est de proposer un procédé de fabrication de transistors bipolaires à hétérojonction destinés à fabriquer des circuits d'émission et de réception de données sur fibres optiques par exemple, ou dans toute autre application à haut débit. Afin de suivre les évolutions de la technologie, de tels transistors se doivent d'être de plus en plus rapides et de plus en plus compacts.

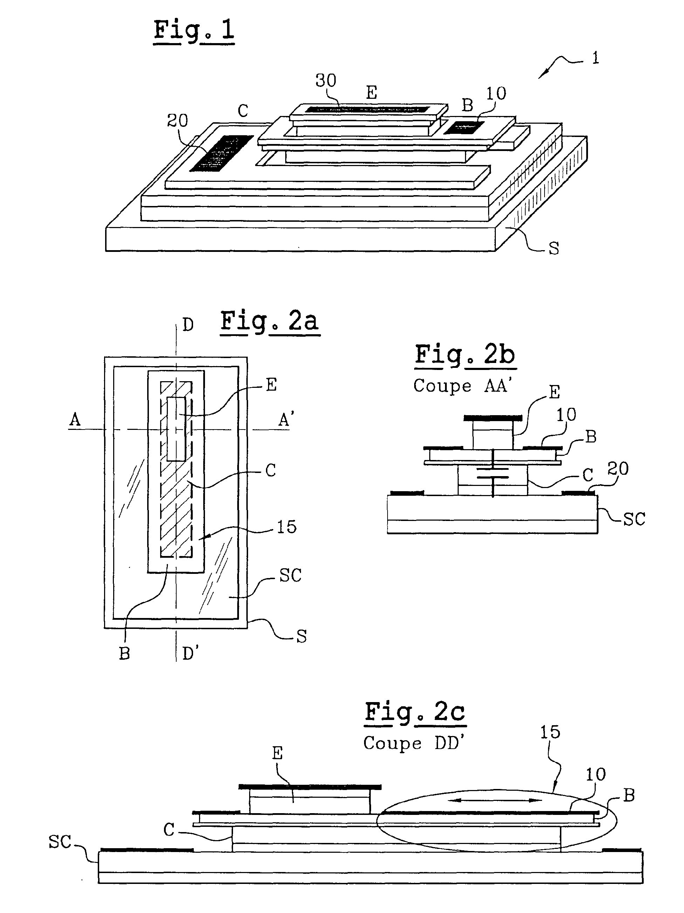

Un transistor bipolaire à hétérojonction sur matériau III-V est illustré sur la figure 1. Un tel transistor 1 est parfaitement maîtrisé dans l'état de la technique. Il est constitué de plusieurs couches épitaxiées sur un substrat S III-V, dans le cas présent de l'InP, les différentes couches étant gravées pour constituer des mesas qui définissent le collecteur C, la base B et l'émetteur E du transistor 1. Des contacts électriques doivent être pris sur chacun des mesas par le dépôt de zones métalliques 10, 20, 30.

Une hétérojonction se situe entre la base et l'émetteur. Les couches de semi-conducteur constituant la base et l'émetteur sont réalisées dans des matériaux différents, la première en InGaAs et la seconde en InP, dopées chacune d'un type différent. L'hétérojonction autorise des dopages de la base très élevés et permet la réalisation d'une base B très fine. On obtient ainsi des fréquences de fonctionnement très élevées.

Selon les applications, le transistor 1 peut être à simple hétérojonction (SHBT) avec une homojonction entre la base B et le collecteur C ; ou à double hétérojonction (DHBT), la seconde hétérojonction se situant entre la base B et le collecteur C.

Afin d'obtenir des transistors plus rapides, il est tout d'abord nécessaire de diminuer la taille du transistor et de réduire les surfaces parasites extrinsèques aux transistors.

Pour réduire les capacités d'interconnexion des transistors, il est nécessaire de les rapprocher les uns des autres. Cependant, une distance minimale entre deux composants est requise afin de limiter les phénomènes d'échauffement. Afin de réduire cette distance, il est donc nécessaire de limiter la dissipation thermique des transistors. Dans le cas d'un transistor bipolaire, cette dissipation thermique est directement liée à la surface de l'émetteur. La réduction des parasites extrinsèques appelle donc la diminution des tailles des transistors.

On rappelle en outre que les performances d'un transistor se mesurent en particulier à sa fréquence de fonctionnement et dépendent de plusieurs paramètres, dont la capacité Base-Collecteur C_{BC}. Il est donc nécessaire de réduire au maximum cette capacité C_{BC} afin de garantir une meilleure fréquence de fonctionnement, et par conséquent une rapidité accrue.

Une première solution consiste à réduire la capacité base-collecteur par gravure sélective. Cette solution est présentée dans la publication "Reduction of Base-Collector Capacitance by undercutting the Collector and Subcollector in GaInAs/InP DHBT's" de Y.Miyamoto, J.M.M.Rios, A.G.Dentai, S.Chandrasekar (AT&T Bell Laboratories) paru le 3 mars 1996 dans IEEE electron device letters, vol.17, NO 3.

Une telle solution est illustrée sur les figures 2a à 2c et consiste essentiellement à sous graver partiellement la couche de collecteur C.

Cette solution a été mise en oeuvre pour un transistor à double hétérojonction (DHBT). La couche de base B est composée de GaInAs et la couche du collecteur C d'InP. Cette dernière est déposée sur au moins une couche de sous-collecteur SC en GaInAs sur laquelle le contact 20 est pris. L'hétérojonction entre la base B et le collecteur C permet de réaliser une sous-gravure sélective du collecteur C par rapport à la base B. Il est donc possible de réduire la surface de collecteur C tout en préservant totalement la base B.

La capacité C_{BC} dépend essentiellement de l'épaisseur de la couche de collecteur C et de la surface commune entre les couches de base B et de collecteur C.

Afin de réduire la capacité C_{BC}, cette publication propose de réduire la surface commune base-collecteur. A cet effet, la couche de collecteur C en InP est gravée sélectivement entre les couches de base B et de sous-collecteur SC.

Il faut noter que cette gravure latérale du collecteur C en InP n'est possible que selon certaines orientations cristallographiques, cette même gravure étant totalement bloquée selon des axes cristallographiques défavorables. Cette solution n'est par conséquent applicable que si le transistor est orienté selon un des axes [001] ou [010] sur une plaquette d'InP découpée dans le plan {100}.

Cette gravure latérale permet de réduire la surface commune base-collecteur, comme illustré sur la figure 2b.

Néanmoins, lorsque l'on considère la coupe longitudinale de la figure 2c, on s'aperçoit que la surface commune base-collecteur reste importante du fait de la surface 15 nécessaire à la prise de contact 10 de la base B.

Cette surface 15 est négligeable pour de grands transistors, mais devient gênante dans le cas d'un transistor de taille réduite où elle peut représenter jusqu'à 60% de la taille du transistor.

Ainsi, le problème principal lié à la diminution de la taille des transistors provient de l'augmentation en proportion des surfaces parasites de semi-conducteur destinées aux prises de contact 10, 20, 30, et plus spécifiquement au contact de la base 10. En particulier, ces surfaces sont de quelques µm². Pour un transistor de 20 µm de long, ces surfaces sont négligeables, alors que pour un transistor de 2 à 3 µm de long, ces mêmes surfaces deviennent proportionnellement importantes et entraînent une dégradation des performances du transistor.

La diminution proportionnelle de ces surfaces parasites impose de sévères contraintes technologiques difficilement compatibles avec les rendements de fabrication imposés par la réalisation de circuits comportant plusieurs centaines de transistors.

Afin de résoudre ce problème de surface parasite liée à la prise de contact de la base, la société NTT propose une solution qui consiste à transférer cette prise de contact en dehors du transistor lui-même au moyen d'un "pont à air" métallique.

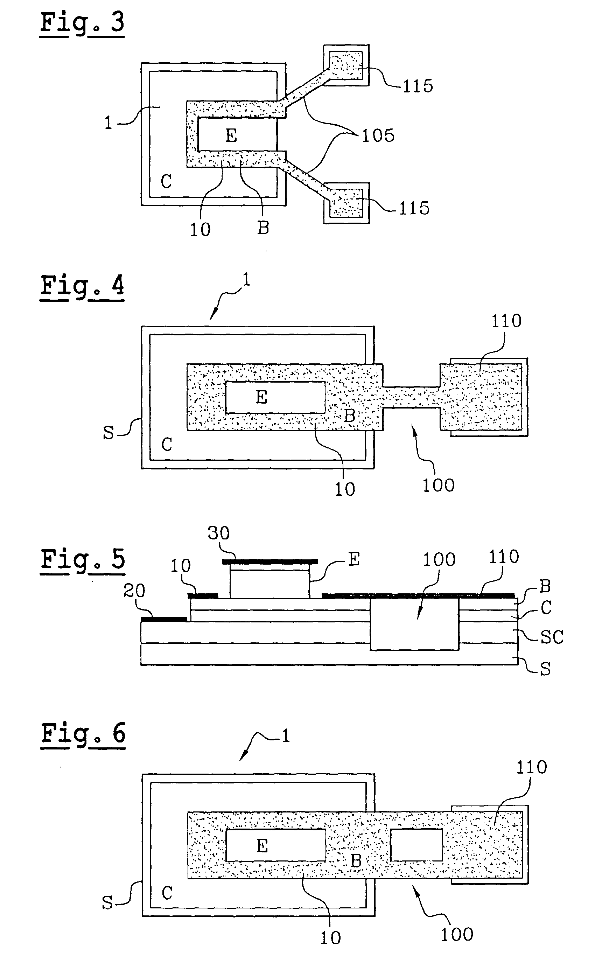

Cette solution, illustrée sur la figure 3, est exposée dans la publication "High performance small InP/InGaAs HBTs with reduced parasitic base-collector capacitance fabricated using a novel base-metal design" de Minoru Ida, Shoji Yamahata, Hiroki Nakajima, Niriyuki Watanabe (NTT Photonics laboratories) In Proc of ISCS, Berlin 22-26 Août 1999.

Cette solution a été mise en oeuvre sur un transistor à simple hétérojonction (SHBT), la base B et le collecteur C étant tous deux composés de InGaAs dopés différemment. Un pont métallique 105 prolonge le métal du contact 10 de la base B vers des plots 115 afin de permettre la réalisation d'un petit transistor 1 débarrassé de la surface parasite liée à la prise de contact 10 de la base B.

Le pont à air métallique 105 est orienté selon la direction cristallographique [010] alors que le transistor est orienté selon la direction [01-1]. Cette implantation particulière permet d'obtenir une vitesse de gravure des couches de collecteur C et de base B sous le pont 105 plus élevée que sur les bords du transistor 1.

Cette solution requiert une implantation particulière du transistor, du pont et des plots qui respecte les contraintes cristallographiques.

De plus, la gravure du pont 105 et celle du transistor 1 étant réalisée simultanément, cela implique une largeur de pont très étroite.

En outre, les plots 115 de contact de la base B doivent être reliés pour permettre une connexion électrique correcte.

De plus, cette solution s'appliquant aux transistors bipolaires à simple hétérojonction SHBT, le collecteur C ne peut pas être sous gravé latéralement comme décrit précédemment car il est de même nature que la base B. Il est donc nécessaire de prévoir une base très étroite pour réduire la surface base-collecteur et la capacité C_{BC}.

La présente invention a pour but de résoudre les inconvénients de l'art antérieur.

A cet effet, l'invention propose un nouveau procédé pour réaliser un pont à air métallique sans contraintes de largeur et indépendant de la direction cristallographique du substrat.

La présente invention a plus particulièrement pour objet un procédé de fabrication d'un transistor bipolaire à double hétérojonction comprenant successivement au moins une couche de sous-collecteur, une couche de collecteur, une couche de base et une couche métallique déposée sur ladite couche de base ; la dite couche métallique étant prolongée vers un plot de contact de la base par un « pont à air » métallique sous gravé, caractérisé en ce que la réalisation dudit « pont à air » comporte les étapes suivantes :
- la réalisation d'une première gravure localisée sous ledit pont, cette première gravure étant sélective de manière à graver latéralement la couche du sous-collecteur ; et
- la réalisation d'une seconde gravure localisée sous ledit pont, cette seconde gravure étant sélective de manière à graver verticalement au moins la couche du collecteur.

Selon une caractéristique, la couche du sous-collecteur est de l'Arséniure d'Indium et de Gallium (GaInAs).

Selon une caractéristique, la couche du collecteur est du Phosphure d'Indium (InP).

Selon un mode de réalisation préférentiel, le transistor comporte en outre une seconde couche de sous-collecteur en Phosphure d'Indium, cette seconde couche de sous-collecteur étant gravée verticalement lors de la seconde gravure sélective.

Selon une caractéristique, le transistor est réalisé sur un substrat semi-isolant en Phosphure d'Indium, le substrat étant en partie gravé verticalement lors de la seconde gravure sélective.

Selon une variante de mise en oeuvre, le "pont à air" métallique est orienté perpendiculairement à une direction cristallographique favorable à la gravure de l'InP, un bord de la zone métallique, un bord du plot de contact et un bord du "pont à air" métallique étant alignés.

La présente invention concerne un transistor bipolaire à double hétérojonction comportant de l'InP dans le collecteur et une zone métallique déposée sur la couche de base, ladite zone métallique s'étendant vers un plot de contact par un « pont à air » métallique sous-gravé, caractérisé en ce que ledit « pont à air » est orienté dans une direction cristallographique défavorable à la gravure de l'InP.

La présente invention se rapporte également à un composant comportant une zone métallique déposée sur des couches épitaxiées sur un substrat semi-isolant en matériau III-V, ladite zone métallique s'étendant vers un plot de contact par un « pont à air » métallique sous-gravé, caractérisé en ce que le composant comporte au moins une couche en InP déposée directement sur le substrat semi-isolant, ladite couche étant gravée sous le « pont à air » métallique.

Le procédé selon l'invention présente l'avantage d'être totalement compatible avec les procédés classiques de fabrication de transistor bipolaire à hétérojonction. Seul le motif du métal de la base est modifié par rapport à un transistor classique.

De plus, le procédé selon l'invention permet de réaliser l'isolation du pont à air selon n'importe quelle orientation cristallographique.

En outre, la capacité C_{BC} du transistor selon l'invention a pu être divisée par deux par rapport à un transistor classique, pour une surface d'émetteur de 2x1.2 µm²; et à un même niveau de performance, la consommation du transistor selon l'invention a été divisée par douze.

D'autres caractéristiques et avantages de l'invention apparaîtront clairement à la lecture de la description qui suit, faite à titre indicatif et non limitatif et en regard des figures sur lesquelles :
- la figure 1, déjà décrite, représente une vue schématique en perspective d'un transistor bipolaire à hétérojonction classique ;
- la figure 2a, déjà décrite, est une vue schématique de dessus d'un transistor bipolaire à hétérojonction réalisé selon un procédé connu de l'art antérieur ;
- la figure 2b, déjà décrite, est une vue en coupe transversale selon AA' de la figure 2a ;
- la figure 2c, déjà décrite, est une vue en coupe longitudinale selon DD' de la figure 2a ;
- la figure 3, déjà décrite, est une vue schématique d'un transistor bipolaire à hétérojonction réalisé selon un autre procédé connu de l'état de la technique ;
- la figure 4 est une vue schématique de dessus d'un transistor bipolaire à hétérojonction selon la présente invention ;
- la figure 5 est une vue en coupe longitudinale de la figure 4 ;
- la figure 6 est une vue schématique de dessus d'un transistor selon une variante de réalisation de la présente invention ;
- les figures 7a à 7d illustrent schématiquement les étapes du procédé de fabrication du transistor selon la présente invention ;
- la figure 8 est un graphe illustrant la fréquence de fonctionnement du transistor en fonction du courant injecté dans le collecteur du transistor selon l'invention.
- la figure 9 est un graphe comparatif illustrant la fréquence de fonctionnement en fonction du courant injecté dans le collecteur entre des transistors de l'état de la technique et des transistors selon l'invention pour différentes surfaces d'émetteur.

La présente invention propose un procédé nouveau pour réaliser le « pont à air » métallique qui prolonge la couche métallique de la base du transistor vers un plot de contact totalement isolé du transistor. Ce procédé associe avantageusement les particularités des couches de semi-conducteur qui constituent la structure d'un transistor bipolaire à double hétérojonction (DHBT).

Comme illustré sur la figure 4, le procédé selon l'invention permet de réaliser le « pont à air » métallique 100 selon une orientation cristallographique quelconque et dans l'alignement du transistor 1. Cela représente un avantage par rapport au procédé connu de NTT en termes d'encombrement et de liberté d'implantation sur la plaquette de semi-conducteur.

La figure 5 est une vue schématique en coupe longitudinale du transistor selon l'invention. On constate aisément que la surface commune base-collecteur est réduite à son minimum sans nuire à la surface nécessaire à la prise de contact de la base 10 qui est prolongée vers le plot 110.

La figure 6 illustre une variante de réalisation du « pont à air » métallique 100. Cette variante exploite un motif particulier du « pont à air » 100 dans lequel on a cherché à éliminer les angles défavorables à la gravure latérale de l'InP. En particulier, la sous gravure de l'InP est bloquée dans les directions [01-1] et [011].

Selon ce mode de réalisation particulier, le « pont à air » 100 est orienté perpendiculairement à une direction cristallographique favorable à la gravure latérale de l'InP, à savoir la direction [001] ou [010], et les bords de la zone métallique 10, du « pont à air » 100 et du plot de contact 110 sont alignés.

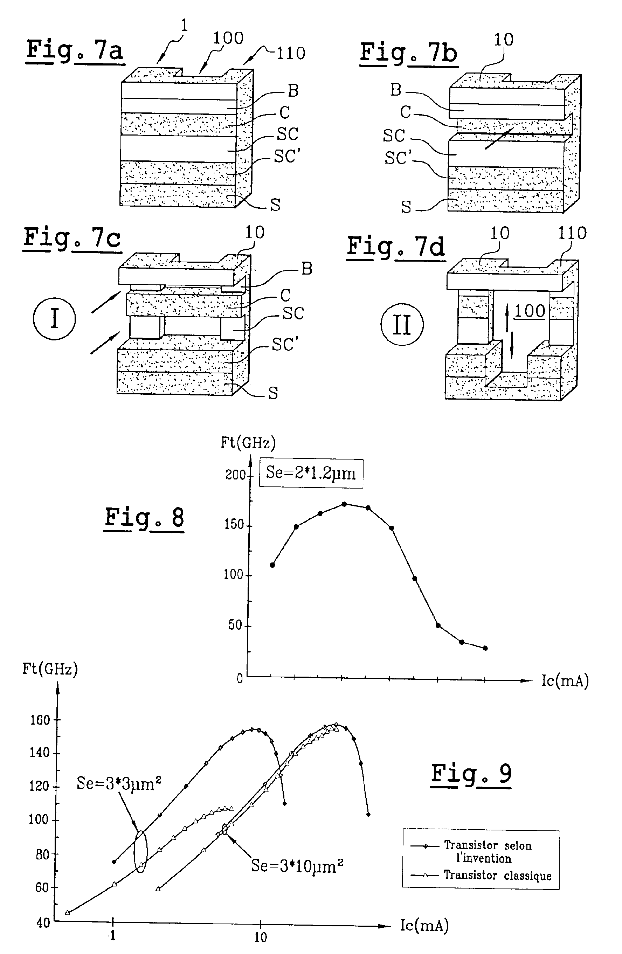

Les figures 7a à 7d illustrent schématiquement les principales étapes du procédé de réalisation du transistor selon l'invention, et plus spécifiquement les étapes d'isolation du « pont à air ». Ces figures décrivent le procédé dans le cas d'un transistor bipolaire à double hétérojonction.

La structure schématique d'un transistor à double hétérojonction est constituée d'une couche d'émetteur en InP déposée sur une couche de base B en InGaAs pour former une première hétérojonction. La seconde hétérojonction se situe entre la base B en InGaAs et le collecteur C en InP.

La couche de collecteur peut avantageusement être déposée sur au moins une couche de sous-collecteur SC réalisée dans un matériau différent et dopée du même type. Ainsi, dans l'exemple de la figure 7a, le collecteur C en InP est déposé sur une première couche de sous-collecteur SC en InGaAs, déposée sur une seconde couche de sous-collecteur SC' en InP elle-même déposée sur le substrat semi-isolant S en InP du transistor. Le contact 20 est réalisé sur la première sous couche SC en InGaAs qui est très conductrice et permet de recueillir les charges. La deuxième sous couche SC' en InP présente une dissipation thermique supérieure à celle de l'InGaAs et permet de dissiper la chaleur du transistor dans le substrat S afin de limiter les risques d'échauffement.

Les figures 7a à 7d sont des vues détaillées de la sous gravure du pont métallique 100, la portion du transistor 1 comportant l'émetteur n'apparaît donc pas.

Le procédé selon l'invention consiste dans un premier temps à déposer une couche de métal 10 sur la couche de base B, cette couche 10 étant déposée selon un motif particulier sous la forme d'un rail 100 qui se prolonge vers un plot de contact 110.

Une première gravure illustrée sur la figure 7b consiste à graver latéralement la couche de collecteur C en InP sur toute sa largeur, comme cela a été décrit en référence à l'art antérieur, afin de réduire la surface commune base-collecteur et par là la capacité C_{BC}. Cette étape n'est possible que dans une certaine orientation cristallographique du transistor sur la plaquette, tel que cela a précédemment été décrit.

Le procédé selon l'invention consiste à graver les couches de collecteur C et de sous-collecteur SC sous le pont 100 afin d'isoler le transistor 1 du plot de contact 110 de la base B. Selon une caractéristique essentielle de l'invention, le procédé de sous-gravure du pont 100 s'effectue en deux étapes. Le transistor 1 et le plot de contact 110 sont protégés par une résine photosensible, laissant le pont 100 découvert.

La première étape, illustrée sur la figure 7c, consiste à réaliser une première gravure I localisée sous le pont 100, cette première gravure étant sélective de manière à graver latéralement la couche du sous-collecteur SC composée de InGaAs. La gravure latérale de l'InGaAs est en effet possible selon n'importe quelle direction cristallographique. Elle peut simplement être plus ou moins rapide selon cette orientation. Une différence de vitesse d'environ 30% a été mesurée entre une direction favorable et une direction défavorable, ce qui reste acceptable.

Cette première gravure permet de dégager un accès vertical à la couche de collecteur C et à la seconde couche de sous-collecteur SC' en InP.

Ainsi, la deuxième étape, illustrée sur la figure 7d, consiste à réaliser une deuxième gravure II localisée sous le pont 100, cette deuxième gravure étant sélective de manière à graver verticalement les couches de collecteur C et de sous-collecteur SC' composées d'InP. Le gravure verticale permet également d'atteindre partiellement le substrat semi-isolant S en InP, et d'isoler ainsi électriquement le bas du plot de contact 110 par rapport au transistor 1. La gravure du substrat S est légère, de l'ordre de 0.1µm environ pour un substrat d'environ 300µm d'épaisseur.

La gravure verticale de l'InP permet une sous-gravure du pont 100 rapide et indépendante de l'orientation cristallographique.

Cette seconde gravure II verticale ne doit cependant pas être prolongée afin de ne pas accentuer la gravure latérale du collecteur C si elle a lieu et risquer d'obtenir une largeur de collecteur inférieure à celle de l'émetteur ce qui ferait chuter les performances du transistor. Dans tous les cas, la gravure verticale est toujours plus rapide que la gravure latérale lorsqu'elle est possible, notamment parce que l'épaisseur des couches à graver est moindre que leur largeur.

Le procédé selon l'invention a été réalisé sur différentes plaquettes et a permis d'obtenir de petits transistors avec de bonnes fréquences de fonctionnement tout en diminuant nettement la consommation en courant. La figure 8 est un graphe illustrant de telles performances.

Un transistor présentant une surface d'émetteur Se de 2^{*}1.2µm avec un pont à air métallique selon l'invention peut atteindre une fréquence de fonctionnement de 150GHz à 2mA avec un pic à 172GHz à 4mA.

On remarque qu'à même niveau de performance, la consommation du transistor selon l'invention a pu être divisée par douze, ce qui diminue d'autant sa dissipation thermique.

La figure 9 est un graphe comparatif qui met en valeur l'importance du procédé selon l'invention pour de petits transistors.

On remarque que pour un transistor présentant une « grande surface » d'émetteur Se de 3^{*}10 µm², le report du contact de la base sur un plot éloigné du transistor ne modifie guère les performance en termes de fréquence et de consommation.

En revanche, pour un transistor de petite taille avec une surface d'émetteur de 3^{*}3 µm², la fréquence de fonctionnement est nettement plus élevée pour un transistor réalisé selon le procédé de la présente invention que pour un transistor classique.

## Revendications

1. Procédé de fabrication d'un transistor bipolaire à double hétérojonction (1) comprenant successivement au moins une couche de sous-collecteur (SC), une couche de collecteur (C), une couche de base (B) et une couche métallique (10) déposée sur ladite couche de base (B) ; la dite couche métallique (10) étant prolongée vers un plot de contact (110) de la base par un « pont à air » métallique (100) sous gravé, caractérisé en ce que la réalisation dudit « pont à air » (100) comporte les étapes suivantes :
- la réalisation d'une première gravure (I) localisée sous ledit pont (100), cette première gravure étant sélective de manière à graver latéralement la couche du sous-collecteur (SC) ; et
- la réalisation d'une seconde gravure (II) localisée sous ledit pont (100), cette seconde gravure étant sélective de manière à graver verticalement au moins la couche du collecteur (C).

2. Procédé selon la revendication 2, caractérisé en ce que la couche du sous-collecteur (SC) est de l'Arséniure d'Indium et de Gallium (GaInAs).

3. Procédé selon l'une des revendications 1 à 2, caractérisé en ce que la couche du collecteur (C) est du Phosphure d'Indium (InP).

4. Procédé selon l'une des revendications 1 à 3, caractérisé en ce que le transistor (1) comporte en outre une seconde couche de sous-collecteur (SC') en Phosphure d'Indium (InP), cette seconde couche de sous-collecteur (SC') étant gravée verticalement lors de la seconde gravure (II) sélective.

5. Procédé selon l'une quelconque des revendications 1 à 4, caractérisé en ce que le transistor est réalisé sur un substrat semi-isolant (S) en Phosphure d'Indium (InP), le substrat (S) étant en partie gravé verticalement lors de la seconde gravure (II) sélective.

6. Procédé de fabrication selon l'une quelconque des revendications précédentes, caractérisé en ce que le "pont à air" métallique (100) est orienté perpendiculairement à une direction cristallographique favorable à la gravure de l'InP, et en ce que un bord de la zone métallique (10), un bord du plot de contact (110) et un bord du "pont à air" métallique (100) sont alignés.

7. Composant obtenu selon l'une quelconque des revendications précédentes, comportant de l'InP dans le collecteur et une zone métallique déposée sur la couche de base, ladite zone métallique s'étendant vers un plot de contact par un « pont à air » métallique sous-gravé, caractérisé en ce que ledit « pont à air » est orienté dans une direction cristallographique défavorable à la gravure de l'InP.

8. Composant obtenu selon l'une quelconque des revendications 1 à 6, comportant une zone métallique (10) déposée sur des couches épitaxiées sur un substrat semi-isolant en matériau III-V, ladite zone métallique (10) s'étendant vers un plot de contact (110) par un « pont à air » métallique (100) sous-gravé, caractérisé en ce que le composant comporte au moins une couche en InP déposée directement sur le substrat semi-isolant, ladite couche étant gravée sous le « pont à air » métallique (100).
